# EUROPÄISCHE PATENTANMELDUNG

(11) **EP 0 713 997 A1**
(43) Veröffentlichungstag der Anmeldung: **29.05.1996**
(21) Anmeldenummer: 95115083.8
(22) Anmeldetag: 25.09.1995
(51) Int. Cl.: F16M 13/00

(54) **Haltevorrichtung für ein Gehäuse**

(30) Priorität: 27.10.1994 DE 9417283 U
(71) Anmelder: Kuhnert, Manfred, D-80538 München (DE)
(72) Erfinder: Kuhnert, Manfred, D-80538 München (DE)
(74) Vertreter: Patentanwälte Beetz - Timpe - Siegfried Schmitt-Fumian - Mayr

(57) **Zusammenfassung**

Die Erfindung betrifft eine Haltevorrichtung für ein Gehäuse mit einem Grundelement (1), einem Fortsatz (2), welcher sich im unteren Bereich des Grundelements (1) von demselben erstreckt und einem Halteelement (3), das mit dem Fortsatz (2) in Verbindung steht, wobei der Fortsatz (2) zur verschiebbaren Aufnahme eines Endstücks des Halteelements (3) ausgebildet ist und der Fortsatz (2) eine Klemmeinrichtung (4) aufweist, die das Endstück des Halteelements (3) in einer vorbestimmten Position festsetzt.

## Beschreibung

Die Erfindung betrifft eine Haltevorrichtung für ein Gehäuse mit einem Grundelement, einem Fortsatz, welcher sich im unteren Bereich des Grundelements von demselben erstreckt und einem Halteelement, das mit dem Fortsatz in Verbindung steht. Die Haltevorrichtung kann insbesondere für Computergehäuse verwendet werden, wobei sie für verschiedene Gehäusegrößen einstellbar ist und ein Verschieben des Computergehäuses in Richtung des Benutzers erlaubt.

Es sind Haltevorrichtungen für Computergehäuse bekannt, welche seitlich an Schreibtischen befestigt werden können. Diese Haltevorrichtungen weisen einen U-förmigen Querschnitt auf und werden mit einem Schenkel seitlich an einen Schreibtisch montiert. Derartige Vorrichtungen bestehen meist aus Kunststoff und werden für bestimmte Gehäusegrößen gefertigt. Somit kann eine derartige Aufnahme gemäß dem Stand der Technik keine unterschiedlichen Computergehäuse sicher aufnehmen, da diese nur für eine Größe gefertigt sind. Sollte nun der Benutzer des Schreibtischs einen anderen Computer mit einer anderen Gehäusegröße verwenden, so muß gemäß dem Stand der Technik eine andere Haltevorrichtung verwendet werden. Dies führt zu einem größeren Kostenaufwand, nicht nur wegen den neu anfallenden Investitionskosten, sondern auch aufgrund der nötigen Montierarbeiten.

Die Aufgabe der Erfindung ist es, eine Haltevorrichtung für ein Gehäuse zu schaffen, welches für verschiedene Gehäusegrößen einstellbar ist und dabei einfach und kostengünstig hergestellt werden kann.

Diese Aufgabe wird durch die Merkmale des Schutzanspruchs 1 gelöst. Die abhängigen Schutzansprüche geben vorteilhafte Ausführungsformen und Weiterentwicklungen der Erfindung an.

Erfindungsgemäß weist die Haltevorrichtung für das Gehäuse einen mit dem Grundelement verbundenen Fortsatz auf, welcher ein Endstück eines Halteelements aufnehmen kann. Dieser Fortsatz ist derart ausgebildet, daß das Endstück des Halteelements verschiebbar aufgenommen werden kann. Weiterhin weist der Fortsatz eine Klemmeinrichtung auf, welche zum Festlegen des Halteelements in einer vorbestimmten Position geeignet ist.

Durch die erfindungsgemäße Ausbildung der Haltevorrichtung kann dieselbe variabel auf unterschiedliche Gehäusegrößen eingestellt werden. Durch ein einfaches Lösen der Klemmeinrichtung kann das Halteelement nach außen oder nach innen verschoben werden und dann in einer vorbestimmten Position festgeklemmt werden. Somit ist eine einfache und sichere Verstellung möglich, welche ein permanentes Festlegen des Gehäuses ermöglicht. Dies ist insbesondere dann wichtig, wenn das Gehäuse ein Computergehäuse ist, welches vor Stössen, Erschütterungen und insbesondere vor einem Herausfallen aus der Halterung geschützt werden soll. Durch ein Herandrücken des verschiebbaren Halteelements an das Computergehäuse und ein anschließendes Festlegen der Klemmeinrichtung kann dasselbe in der Haltevorrichtung verklemmt werden, so daß eine auf das Gehäuse aufgebrachte Stoßkraft nicht zu einem Herausrutschen des Gehäuses aus der Haltevorrichtung führen kann. Somit kann erfindungsgemäß eine sichere und dauerhafte Halterung für Gehäuse ermöglicht werden, welche zudem auch variabel einstellbar ist.

Erfindungsgemäß kann der Fortsatz einen kreisringförmigen Querschnitt aufweisen und senkrecht von dem Grundelement abstehen. Weiterhin kann die Klemmeinrichtung aus einer Rändelschraube gebildet sein, welche das in den Fortsatz geschobene Endstück des Halteelements kraftschlüssig festlegt. Die Ausbildung der Klemmeinrichtung als Rändelschraube erleichtert das Lösen und Festlegen des Halteelements in dem Fortsatz, da die Bedienungsperson die Rändelschraube einfach betätigen kann und zudem ohne besonderen Kraftaufwand eine ausreichende Klemmkraft auf das Halteelement dadurch ausgeübt werden kann, daß das durch die Bedienungsperson aufgebrachte Drehmoment über ein Gewinde der Rändelschraube und die durch das Gegengewinde im Fortsatz entstehende Gegenkraft in eine ausreichende Klemmkraft umgewandelt wird. Es können je nach Anwendung auch andere Klemmeinrichtungen verwendet werden, wie z.B. eine verrastende Verbindung zwischen dem Fortsatz und dem Halteelement.

Weiterhin kann das Halteelement U-förmig ausgebildet sein, wobei sich das Endstück senkrecht aus der durch das U gebildeten Ebene erstreckt und einen kreisförmigen Querschnitt aufweisen kann. Durch die U-förmige Ausbildung des Halteelements wird zum einen Material gespart und zum anderen eine ausreichende Festigkeit erzielt. Weiterhin bietet die Ausbildung des Halteelements mit einem kreisförmigen Querschnitt den Vorteil, daß Standardrundeisen als Rohlinge verwendet werden können, was wiederum die Material- und Bearbeitungskosten senkt.

Weiterhin kann das Grundelement einstückig und H-förmig ausgebildet sein und einen flachen Querschnitt aufweisen. Durch die einstückige Ausbildung des Grundelements werden wiederum Bearbeitungskosten durch sonst eventuell notwendige Verschraubungen oder vorzunehmende Schweißnähte gesenkt. In vorteilhafter Weise kann das Grundelement durch eine Laserbearbeitung gefertigt werden, so daß in einem Arbeitsgang sowohl die Form als auch alle nötigen Bohrungen hergestellt werden können.

Zur sicheren Aufnahme des Gehäuses kann zudem eine Auflage vorgesehen sein, welche an einem Ende einen U-förmigen Abschnitt aufweisen kann. Dieser U-förmige Abschnitt der Auflage kann unter einem Fortsatz angeordnet werden, wobei der Abschnitt über die Rändelschraube fixiert werden kann, welche teilweise durch ein in dem Abschnitt vorgesehenes Langloch geführt werden kann. Dadurch ist es möglich, daß ein Einstellen der Haltevorrichtung auch dann vorgenommen werden kann, wenn die Auflage eingesetzt ist. Ein Einstellen erfolgt in vorteilhafter Weise lediglich dadurch, daß die Rändelschrauben gelöst werden, wodurch auch die Auflage nicht mehr gegen den Fortsatz gedrückt wird. Dadurch kann nun das Halteelement verschoben werden, ohne durch die Auflage in irgendeiner Form behindert zu werden. Nach erfolgter Einstellung der Haltevorrichtung können die Rändelschrauben wieder festgelegt werden, wodurch die Rändelschraube, welche durch das Langloch in dem Abschnitt verläuft, denselben und damit die Auflage festlegt. Damit ist die Auflage und das darauf befindliche Gehäuse sicher und dauerhaft festgelegt.

Zur Festlegung der Haltevorrichtung kann das Grundelement an den oberen Enden der Schenkel angeordnete separate Befestigungsstücke aufweisen, welche für eine hängende Montage der Haltevorrichtung geeignet sind.

Durch die erfindungsgemäße Ausbildung der Haltevorrichtung kann in vorteilhafter Weise ein variables und dabei sicheres Halten von Gehäusen erzielt werden. Durch die vorteilhafte Ausbildung der erfindungsgemäßen Haltevorrichtung kann ein Einstellen derselben einfach und schnell erfolgen und es können viele standardteile eingesetzt werden, was wiederum die Herstellungskosten und die Materialkosten senkt.

Im folgenden werden Ausführungsbeispiele der Erfindung anhand von Zeichnungen detailliert beschrieben. Es zeigen:
- Fig. 1: eine Haltevorrichtung gemäß einer Ausführungsform der Erfindung,
- Fig. 2: eine Haltevorrichtung gemäß einer weiteren Ausführungsform der Erfindung,
- Fig. 3: eine Auflage für das Gehäuse,
- Fig. 4: eine Haltevorrichtung gemäß der Erfindung mit einer in Position gebrachten Auflage, und
- Fig. 5: eine Haltevorrichtung gemäß einer Ausführungsform der Erfindung mit einer in Position gebrachten Auflage.

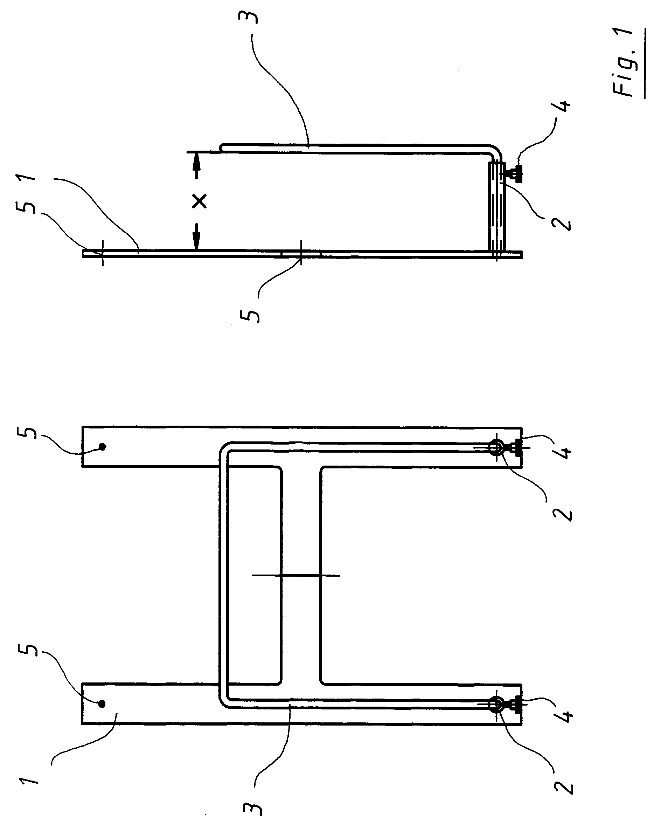

In der Fig. 1 ist ein Grundelement 1 dargestellt, welches H-förmig ausgebildet ist. Das Grundelement 1 weist einen flachen Querschnitt auf und ist einstückig ausgebildet. Die Herstellung des Grundelements 1 kann durch eine Laserbearbeitung erfolgen, welche das Grundelement 1 mit allen nötigen Bohrungen 5 in einem Arbeitsgang fertigt. An dem Grundelement 1 sind jeweils an den unteren Enden der Schenkel Fortsätze 2 angeordnet. Die Fortsätze 2 sind in einem 90°-Winkel zu der Ebene angeordnet, in der sich das Grundelement 1 befindet. Der Fortsatz 2 kann durch einen Preßsitz mit dem Grundelement 1 verbunden sein, wobei ein einen kleineren Durchmesser aufweisendes Abschlußstück des Fortsatzes 2 in eine entsprechende Bohrung in dem Grundelement eingepreßt werden kann. Der Fortsatz 2 kann auch durch andere Verfahren mit dem Grundelement 1 verbunden werden, wobei der Fortsatz 2 mit dem Grundelement 1 verklebt oder verschweißt werden kann. Der Fortsatz 2 weist einen kreisringförmigen Querschnitt auf, welcher dem Durchmesser eines Endstücks eines Halteelements 3 derart angepaßt ist, daß sich das Halteelement 3 in dem Fortsatz 2 verschieben kann. Durch ein Verschieben des Halteelements 3 kann der mit X in der Fig. 1 bezeichnete Abstand zur Aufnahme des Gehäuses verändert werden, wobei das Halteelement 3 nach dem Einsetzen des Gehäuses oder auch vorher durch ein Drehen einer Klemmeinrichtung 4 festgelegt werden kann. Die Klemmeinrichtung 4 kann aus einer Rändelschraube gebildet sein, welche mit ihrem Gewindeteil mit einer Gewindebohrung in dem Fortsatz derart in Eingriff kommt, daß ein Verdrehen der Rändelschraube in eine Richtung ein Nachinnenbewegen derselben zur Folge hat, und umgekehrt. Dadurch kann das sich in dem Fortsatz befindende Endstück des Halteelements 3 in einer gewünschten Position festgeklemmt werden.

Im Bereich der oberen Enden der Schenkel des H-förmigen Grundelements 1 sind die Bohrungen 5 vorgesehen, welche zur Befestigung des Grundelements 1 an einem Bügelfuß eines Schreibtisches dienen. Das Grundelement 1 kann über diese Bohrungen 5 seitlich an ein Standelement des Schreibtisches montiert werden, wobei als Montagepunkte vorgefertigte Bohrungen in dem Standelement des Schreibtisches verwendet werden können. Das Grundelement 1 kann an die seitlichen Standfüße des Standelements angebracht werden, es kann aber auch an die Querverstrebung des Standelements montiert werden.

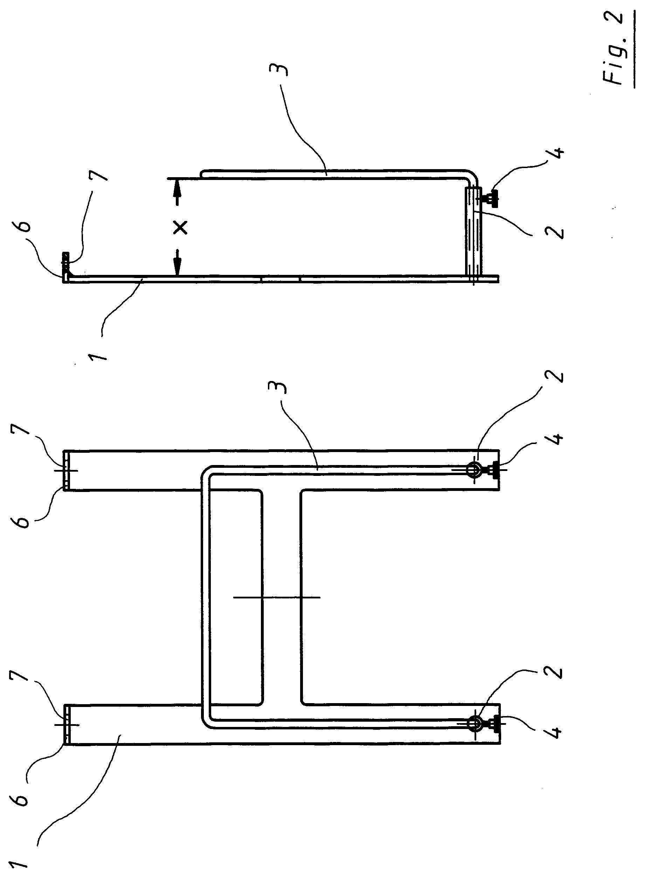

In der Fig. 2 ist eine Haltevorrichtung dargestellt, welche am Grundelement 1 um 90° angestellte Befestigungsstücke 6 aufweist. Die Befestigungsstücke 6, welche sich am oberen Ende der Schenkel des Grundelements 1 befinden, können an das Grundelement 1 geschweißt sein; sie können aber auch einstückig mit dem Grundelement ausgebildet werden. Weiterhin sind auch andere Verbindungsmöglichkeiten denkbar, wie ein Verkleben, Verpressen usw.. In jedem der Befestigungsstücke 6 befindet sich eine Bohrung 7, welche zur Befestigung des Grundelements 1 an dem Tisch dient. Durch ein entsprechendes Einführen von Schrauben in die Bohrungen 7 kann das Grundelement und damit die Haltevorrichtung an dem Bügel eines Standelements angebracht werden, wenn der Bügel etwas unterhalb der Tischplatte angeordnet ist, so daß zwischen dem Bügel des Standelements und der Unterseite der Tischplatte noch etwas Luft verbleibt. In diesen Zwischenraum können nun die Befestigungsstücke eingebracht werden, so daß die Haltevorrichtung hängend montiert wird. Die Bohrungen sowie die Abstände der Schenkel des Grundelements 1 können schon vorgefertigten Bohrungen in dem Bügel des Standelements angepaßt sein.

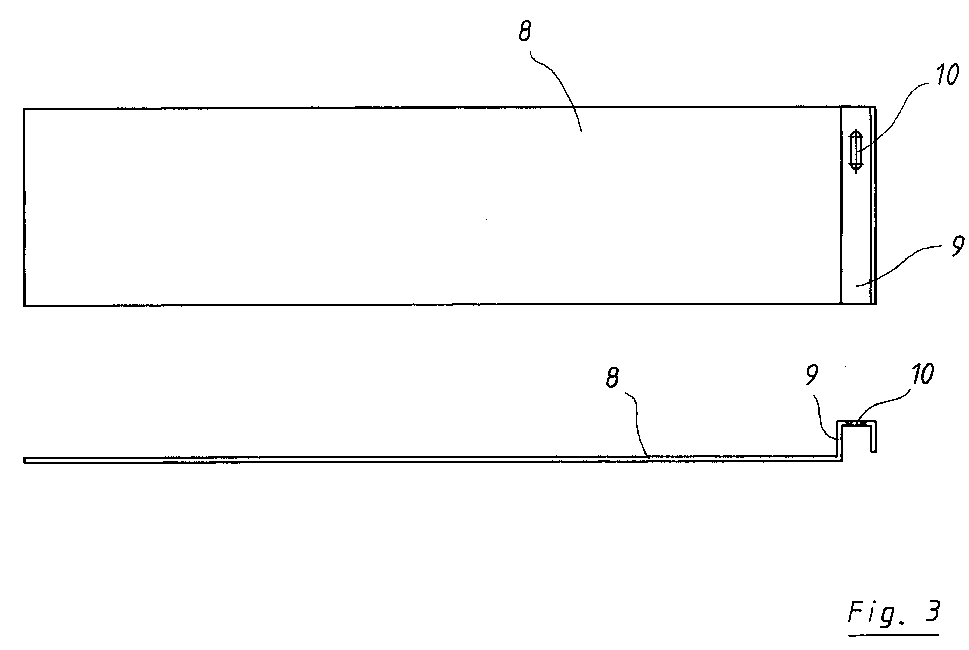

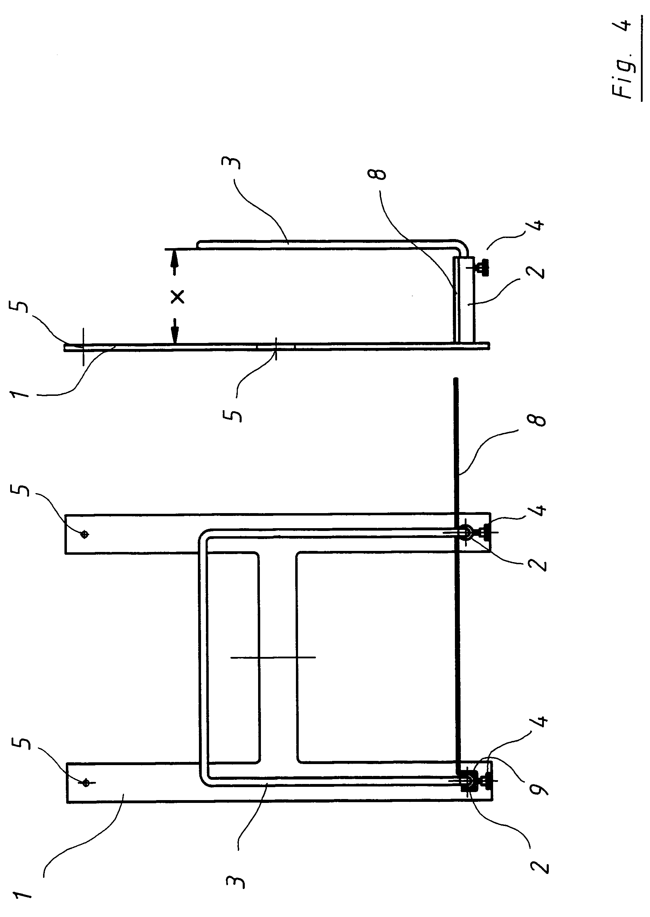

Die Fig. 3 zeigt eine Auflage 8, die einen U-förmigen Abschnitt 9 aufweist. Der Abschnitt 9 weist eine derartige Form auf, daß er den Fortsatz 2 teilweise umschließen kann, vergl. auch Fig. 4. Weiterhin weist der Abschnitt 9 an seiner Basis ein Langloch 10 auf. Dieses Langloch 10 dient zum Hindurchführen des Gewindeabschnitts der Rändelschraube, so daß die Auflage 8 bei einer gelockerten Rändelschraube in den vorgegebenen Grenzen des Langlochs 10 verschiebbar ist, dadurch kann die Auflage 8 in optimaler Weise zwischen dem Grundelement 1 und dem U-förmigen Abschnitt des Halteelements 3 zur Aufnahme des Gehäuses einjustiert werden. Der Durchmesser der durch das Langloch 10 geführten Rändelschraube ist stufenförmig aufgebaut. Zunächst weist die Rändelschraube einen das Gewinde aufweisenden Abschnitt auf. Dieser Abschnitt kann durch das Langloch 10 geführt werden. Daran anschließend weist die Rändelschraube einen Abschnitt mit einem vergrößerten Durchmesser auf. Dieser Durchmesser ist größer als die Breite des Langlochs 10, so daß bei einer eingeschraubten Rändelschraube die Auflage 8 vor einem Herunterfallen gesichert ist und durch dieselbe festgelegt werden kann. Daran schließt sich der gerändelte Abschnitt mit einem wiederum größeren Durchmesser an. Die Auflage wird somit zum einen durch die Rändelschraube gehalten und zum anderen durch ein in Anlagebringen mit dem zweiten Fortsatz 2. Damit ist ein einfaches Einsetzen der Auflage 8 zwischen den Fortsätzen 2 möglich und die Auflage 8 kann weiterhin einfach und sicher festgelegt werden. Dies ist insbesondere dann wichtig, wenn beispielsweise ein Computergehäuse in der Haltevorrichtung derart aufgenommen wird, daß es dezentral in die Haltevorrichtung eingesetzt wird.

Wie in Fig. 4 dargestellt kann durch die besondere Ausbildung der Auflage 8 das Computergehäuse beispielsweise etwas nach rechts in der linken Darstellung der Fig. 4 verschoben werden, ohne daß es zu Instabilitäten der Halterung kommt. Somit kann die Haltevorrichtung über in einem Standelement eines Schreibtischs angeordnete vorgefertigte Bohrungen montiert werden. Ein derartiges Montieren mittels vorgefertigter Bohrungen in dem Standelement vereinfacht die Montage der Haltevorrichtung erheblich. Es treten jedoch dann Probleme auf, wenn die vorgefertigten Bohrungen in dem Standelement kein Anordnen des Gehäuses nahe der Seite des Schreibtisches ermöglichen, welche zum Bearbeiter hin gewandt ist. Ein solches Anordnen der Haltevorrichtung kann auch dann nötig sein, wenn dieselbe durch die Konstruktion des Standelements bedingt nicht oder nur durch größeren technischen Aufwand zum Bearbeiter hin gerichtet angeordnet werden kann. Dies kann z.B. bei einem Bügelfußschreibtisch der Fall sein. Um diese Probleme zu lösen, dient die Auflage 8 dazu, die Haltevorrichtung dennoch an den vorgefertigten Stellen des Schreitischstandelements anzuordnen und damit eine einfache Montage zu ermöglichen, ohne daß die Bearbeitungsperson auf den erhöhten Bedienungscomfort verzichten muß, welcher daraus resultiert, daß das Computergehäuse in Richtung derselben verschoben werden kann. Dies wird erfindungsgemäß durch die vorteilhafte Ausgestaltung der Auflage 8 erzielt, und zwar dadurch, daß die Auflage an der dem U-förmigen Abschnitt 9 gegenüberliegenden Seite über den zweiten Fortsatz 2 hinausragt. Dieser hinausragende Teil der Auflage 8 weist nun in Richtung der Bedienungsperson, so daß das Computergehäuse einfach auf der Auflage 8 in Richtung auf die Bedienungsperson verschoben werden kann. Dadurch ist weiterhin ein einfaches Montieren der Haltevorrichtung möglich und die Bedienungsperson kann das Computergehäuse in seine Richtung verschieben, so daß eine ergonomisch günstigere Arbeitsposition realisiert werden kann.

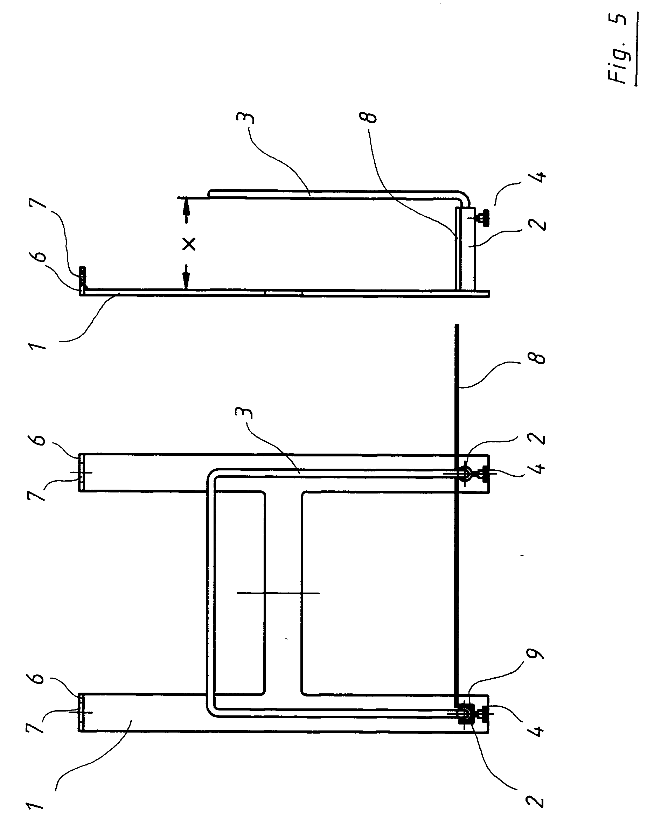

Die Fig. 5 ist eine Darstellung des Grundelements 1 mit Befestigungsstücken 6, wobei eine Auflage 8 eingesetzt ist.

Es sei an dieser Stelle angemerkt, daß die Auflage 8 auch unabhängig von der Haltevorrichtung eingesetzt werden kann. Es ist denkbar, daß die Auflage 8 auch als Regalboden eingesetzt werden kann, bei entsprechender Anordnung von geeigneten Fortsätzen.

## Patentansprüche

1. Haltevorrichtung für ein Gehäuse, mit
- einem Grundelement (1),
- einem Fortsatz (2), welcher sich im unteren Bereich des Grundelements (1) von demselben erstreckt und
- einem Halteelement (3), das mit dem Fortsatz (2) in Verbindung steht,
dadurch **gekennzeichnet,** daß
- der Fortsatz (2) zur verschiebbaren Aufnahme eines Endstücks des Halteelements (3) ausgebildet ist und
- der Fortsatz (2) eine Klemmeinrichtung (4) aufweist, die das Endstück des Halteelements (3) in einer vorbestimmten Position festsetzt.

2. Haltevorrichtung nach Anspruch 1,
dadurch gekennzeichnet, daß
der Fortsatz (2) einen kreisringförmigen Querschnitt aufweist und sich senkrecht von dem Grundelement erstreckt und
die Klemmeinrichtung (4) aus einer Rändelschraube gebildet ist, die das in den Fortsatz (2) geschobene Endstück des Halteelements (3) kraftschlüssig festlegt.

3. Haltevorrichtung nach Anspruch 1 oder 2,
dadurch gekennzeichnet, daß
das Halteelement (3) U-förmig ausgebildet ist, wobei sich das Endstück senkrecht aus der durch das U gebildeten Ebene erstreckt und einen kreisförmigen Querschnitt aufweist.

4. Haltevorrichtung nach zumindest einem der Ansprüche 1 bis 3,
dadurch gekennzeichnet, daß
das Grundelement (1) einstückig und H-förmig ausgebildet ist und einen flachen Querschnitt aufweist.

5. Haltevorrichtung nach zumindest einem der Ansprüche 1 bis 4,
dadurch gekennzeichnet, daß
eine Auflage (5) für das Gehäuse vorgesehen ist, die an einem Ende einen U-förmigen Abschnitt (6) aufweist.

6. Haltevorrichtung nach zumindest einem der Ansprüche 1 bis 5,
dadurch gekennzeichnet, daß
der Abschnitt (6) an seiner Basis zumindest ein Langloch (7) zum teilweisen Hindurchführen der Rändelschraube aufweist.

7. Haltevorrichtung nach zumindest einem der Ansprüche 1 bis 6,
dadurch gekennzeichnet, daß
das Grundelement (1) an den oberen Enden der Schenkel um 90 ° angestellte Befestigungsstücke (6) aufweist.

8. Haltevorrichtung nach zumindest einem der Ansprüche 1 bis 7,
dadurch gekennzeichnet, daß
das Grundelement (1) aus einem Stück gefertigt ist.

9. Haltevorrichtung nach zumindest einem der Ansprüche 1 bis 8,
dadurch gekennzeichnet, daß
das Grundelement (1), der Fortsatz (2), das Halteelement (3) und die Klemmeinrichtung (4) aus dem gleichen oder aus unterschiedlichen Materialien hergestellt sind, wobei metallische Werkstoffe und Plexiglas unter den verwendbaren Materialien sind.
